# EUROPÄISCHE PATENTANMELDUNG

(11) **EP 4 391 256 A1**
(43) Veröffentlichungstag der Anmeldung: **26.06.2024**
(21) Anmeldenummer: 23218511.6
(22) Anmeldetag: 20.12.2023
(51) Int. Cl.: H02B 1/28, E05G 1/02

(54) **BRANDSCHUTZGEHÄUSE**

(30) Priorität: 20.12.2022 CH 15362022; 28.08.2023 CH 9132023
(71) Anmelder: Swibox AG, 3175 Flamatt (CH)
(72) Erfinder: Bracher, Christian, 3363 Oberönz (CH); Gerber, Philipp, 3007 Bern (CH); Wirth, Walter, 90455 Nürnberg (DE); Ghazi Wakili, Karim, 8450 Andelfingen (CH); Rime, Benjamin, 2504 Bienne (CH)
(74) Vertreter: Gachnang AG Patentanwälte

(57) **Zusammenfassung**

Das Brandschutzgehäuse umfasst eine Wandung, die einen Innenraum umschliesst und gegenüber einem Aussenraum begrenzt. Mindestens ein Abschnitt der Wandung umfasst eine Aussenplatte (11) und eine Innenplatte (13) zum Erschweren der Übertragung von Wärme vom Aussenraum in den Innenraum. Die Aussenplatte (11) umfasst ein Material mit gebundenem Wasser in der Form von glasfaserverstärktem Leichtbeton.

## Beschreibung

Gegenstand der Erfindung ist ein Brandschutzgehäuse gemäss dem Oberbegriff des Patentanspruchs 1.

An vielen Orten wie z.B. in Tunnels, Spitälern oder Datencentern ist es wichtig, die Funktion elektronischer Einrichtungen auch im Fall eines Brandes möglichst lange aufrechtzuerhalten.

Es ist bekannt, elektronische Einrichtungen in speziellen Brandschutzgehäusen bzw. -räumen anzuordnen, die im Fall eines Brandes temporär einen Hitzeschutz bewirken. Dadurch kann die Funktion der elektronischen Einrichtungen selbst bei hohen Umgebungstemperaturen, wie sie im Fall eines Brandes auftreten, während einer definierten Minimaldauer aufrechterhalten werden. Ein Material, das bei solchen Brandschutzsystemen häufig verwendet wird, ist Gips. Gips enthält gebundenes Wasser, welches bei hohen Temperaturen freigesetzt wird und dadurch einen Kühlungseffekt hat.

In ähnlicher Weise kann auch die Umgebung von elektronischen Einrichtungen vor Hitze geschützt werden, die z.B. aufgrund eines Defekts durch diese elektronischen Einrichtungen selbst verursacht wird. Solche Situationen können insbesondere bei einem Akkubrand entstehen. Beim Explodieren eines Akkus können in einem Gehäuse bzw. in einem von einer Wandung umschlossenen Raum hohe Temperaturen und Drücke entstehen. Deshalb ist bei solchen Gehäusen bzw. Räumen eine ausreichende Stabilität der Wandung besonders wichtig.

Aus der EP2993746A1 ist ein Brandschutzsystem bekannt, welches einen Innenraum ein- oder mehrseitig abschliesst. Das Brandschutzsystem umfasst mindestens eine Wand aus zwei beabstandet zueinander gehaltenen Schalen, die einen dazwischenliegenden Zwischenraum begrenzen. Die Wand kann Gips als Basismaterial umfassen. Zumindest die äussere Schale kann zur Erhöhung der Stabilität aus zement- und/oder faserverstärktem Material hergestellt sein. Der Innenraum ist über Lüftungsöffnungen und Durchgänge in den Schalen mit dem Aussenraum verbunden. Im Falle eines Brandes werden die Lüftungsöffnungen durch aufgeschäumten Karbonschaum verschlossen.

EP3907838A1 offenbart ein Brandschutzgehäuse mit einem Korpus, der mindestens eine Korpuswand umfasst, die aus einem Plattenverbund mit mindestens drei Platten gefertigt ist. Die äussere Platte ist eine Brandschutzplatte. Diese enthält kristallin gebundenes Wasser bzw. Kristallwasser. Im Brandfall setzt die Brandschutzplatte bei hohen Temperaturen Wasser frei, wodurch das Gehäuse gekühlt wird. Die Brandschutzplatte kann eine Kunststoffbeschichtung aufweisen, die im Brandfall abbrennt und die Freisetzung von Wasser ermöglicht. Innen angrenzend an die Brandschutzplatte folgen eine Mineralfaserplatte als Dämmschicht und eine Kalziumsilikatplatte, die Wasser aufnehmen und wieder abgeben kann und dadurch den Innenraum des Gehäuses im Brandfall schützt. Das Gehäuse kann einen oder mehrere durch den Plattenverbund durchführende oder an wenigstens eine Platte des Plattenverbundes angrenzende Lüftungskanäle eines Lüftungssystems umfassen. Zum Durchführen von Kabeln kann zwischen dem Plattenverbund der Decke und der Rückwand ein Schott aus zwei Mineralfaserplatten und Blechen mit Öffnungen vorgesehen sein.

DE4036735A1 betrifft ein Deckenelement für eine Brandschutz-Zwischendecke. Das Deckenelement umfasst mindestens zwei Platten aus einem schwer entflammbaren oder nicht brennbaren Mineralfaserwerkstoff, die beabstandet parallel zueinander angeordnet sind. Als Träger und Abstandhalter dienen Profilleisten aus Metall. Zwei an sich gegenüberliegenden Längsrändern der Platten angeordnete Profilleisten sind durch eine oder mehrere Traversen miteinander verbunden.

Brandschutzgehäuse umfassen eine Wandung, die einen Innenraum umschliesst und gegenüber einem Aussenraum begrenzt.

Eine wichtige Eigenschaft von Brandschutzgehäusen ist deren Fähigkeit, im Falle eines Brandes im Aussenraum die Temperatur im Innenraum möglichst lange unterhalb einer definierten Maximaltemperatur zu halten. Dadurch kann der Funktionserhalt wichtiger Einrichtungen im geschützten Innenraum während einer vorgegebenen Minimaldauer sichergestellt werden.

Alternativ oder zusätzlich können Brandschutzgehäuse auch dazu ausgebildet sein, den Aussenraum vor den Auswirkungen eines Brandes im Innenraum zu schützen. Solche Brände können beispielsweise durch die Explosion eines Akkus im Innenraum entstehen.

Entsprechend der jeweiligen örtlichen Gegebenheiten kann die Wandung eines Brandschutzgehäuses einen oder mehrere Abschnitte umfassen, die kristallin gebundenes Wasser enthalten. Solche Wandungsabschnitte wirken wärmedämmend und können durch Verdampfen von kristallin gebundenem Wasser zusätzlich einen Kühleffekt bewirken.

Bei Brandschutzgehäusen, die an nicht brennbare Wandungsabschnitte eines Bauwerks angrenzen, können diese Wandungsabschnitte als Teil der Wandung des Brandschutzgehäuses verwendet werden. Dazu eignen sich insbesondere Boden-, Wand- und Deckenabschnitte des Bauwerks, die vorzugsweise aus bewehrtem Mauerwerk oder Beton gefertigt sind. Solche Wandungsabschnitte können aufgrund ihrer wärmedämmenden und/oder wärmeleitenden Wirkung dazu beitragen, dass die Temperatur im Innenraum bei hohen Temperaturen ausserhalb des Brandschutzgehäuses nur langsam steigt.

Bei Brandschutzgehäusen mit einer Brandschutzplatte ist die Dauer bis zum Überschreiten einer vorgegebenen Maximaltemperatur im Gehäuseinneren im Falle eines Brandes abhängig von verschiedenen Faktoren wie z.B. Dicken, Materialien und Anordnung von Platten eines oder mehrerer Wandungsabschnitte. Bei Gehäusen mit dickeren Platten kann die Temperatur im Gehäuseinneren länger unter der vorgegebenen Maximaltemperatur gehalten werden, wenn die Aussentemperatur im Falle eines Brandes sehr hoch ist. Bei dickeren Platten können jedoch das grössere Gewicht und der grössere Platzbedarf nachteilig sein. Zudem sind stärkere Trägerstrukturen erforderlich. Der Werkstoff jeder Platte kann bei einem oder mehreren Wandungsabschnitten des Brandschutzgehäuses wichtige Eigenschaften der Gehäusewandung bestimmen. Solche Eigenschaften sind z.B. Wärmedämmung, Kühlwirkung, mechanische Stabilität, Hitzebeständigkeit, Gewicht und Volumen. Bei Anordnungen mit einem Verbund mehrerer Platten können solche Eigenschaften kombiniert und weiter optimiert werden.

Eine Aufgabe der vorliegenden Erfindung besteht deshalb darin, ein stabiles und vergleichsweise leichtes Brandschutzgehäuse zu schaffen, dessen Wandung ein effizienter Hitzeschutz zwischen einem Innenraum und einem Aussenraum ist.

Diese Aufgabe wird gelöst durch ein Brandschutzgehäuse gemäss den Merkmalen des Patentanspruchs 1.

Das Brandschutzgehäuse umfasst eine Wandung, die einen Innenraum umschliesst und gegenüber einem Aussenraum begrenzt. Zumindest ein Abschnitt dieser Wandung, beispielsweise eine Seiten-, Boden- oder Deckenwand oder eine Tür, umfasst zwei Platten. Diese können durch ein Gestell beabstandet zueinander gehalten sein und einen dazwischenliegenden Zwischenraum begrenzen. Die Luft bzw. allgemein das Gas im Zwischenraum zwischen den Platten ist eine Isolationsschicht, die den Wärmefluss zwischen dem Aussenraum und dem Innenraum wirksam behindert. Dies gilt insbesondere für die Übertragung von Wärme durch Wärmeleitung. Alternativ können zwei Platten auch aneinander angrenzend angeordnet sein. Dies entspricht einer Plattenanordnung, bei der die Breite des Zwischenraums näherungsweise Null ist.

Zumindest die äussere Platte bzw. die aussen an den Zwischenraum angrenzende Aussenplatte umfasst einen Werkstoff, der gebundenes Wasser enthält. Die äussere Platte kann z.B. eine Leichtbetonplatte umfasssen, insbesondere eine zementgebundene, glasfaserbewehrte Leichtbetonplatte, wie sie z.B. von der Firma James Hardie Europe GmbH unter dem Markennamen "Aestuver" angeboten wird. Solche Aussenplatten sind nicht brennbar, haben eine hohe Druckfestigkeit (ca. 6 bis 20 N/mm²) und Biegezugfestigkeit (ca. 2.8 bis 5 N/mm²) und können bei hohen Temperaturen Wasserdampf nach aussen und/oder in den Zwischenraum abgeben, falls ein solcher vorhanden ist. Weitere Vorteile solcher Platten sind deren hohe Abriebfestigkeit, Wasser- und Frostbeständigkeit und Reinigungsfähigkeit sowie deren geringe Dichte (ca. 625 bis 965 kg/m3, und geringe Wärmeleitfähigkeit (ca. 0.125 bis 0.21 W/m K). Alternativ können auch andere Leichtbetonplatten mit zumindest teilweise ähnlichen Eigenschaften verwendet werden. Besonders vorteilhaft ist dabei eine Kombination von geringer Dichte und geringer Wärmeleitfähigkeit.

Die Innenplatte ist vorzugsweise eine Dämmplatte, die eine hohe Stabilität und gute wärmedämmende Eigenschaften hat. Die Innenplatte kann ein- oder mehrschichtig aufgebaut sein. Sie kann einen Werkstoff, der gebundenes Wasser enthält umfassen. Sie kann insbesondere eine glasfaserbewehrte Leichtbetonplatte umfassen. Vorzugsweise umfasst die Innenplatte auf der äusseren Seite eine Wärmestrahlung reflektierende Schicht, beispielsweise eine Folie aus Metall, insbesondere eine Aluminiumfolie.

Bei weiteren Ausführungsformen kann auch die innen an den Zwischenraum angrenzende Innenplatte aus einem Werkstoff gefertigt sein, der gebundenes Wasser enthält. Vorzugsweise ist zwischen der Innenplatte und dem Innenraum eine zusätzliche Schutzschicht angeordnet, die das Eindringen von Wasserdampf in den Innenraum und/oder die Übertragung von Wärme in den Innenraum verhindert bzw. erschwert. Die Schutzschicht kann z.B. eine MDF-Platte, eine Kunststoffschicht oder eine Metallfolie sein. Optional kann auch aussen an der Aussenplatte eine Schutzschicht angeordnet sein, vorzugsweise eine Folie oder ein dünnes Metallblech, welche Wärmestrahlung von aussen gut reflektieren. Solche Schutzschichten haben vorzugsweise nur eine geringe Masse und entsprechend eine geringe Wärmekapazität. Dadurch wird die Übertragung von Wärme an die Aussenplatte durch Wärmeleitung erschwert. Als Schutzschicht eignet sich z.B. eine auf der Oberfläche der Aussenplatte abgeschiedene, Wärme reflektierende dünne Metallschicht. Dünne, massearme Schutzschichten haben eine geringe Wärmekapazität und können selbst dann nur wenig Energie durch Wärmeleitung aufnehmen, wenn sie gute Wärmeleiter sind. Dickere Schutzschichten, z.B. Metallplatten mit einer Dicke in der Grössenordnung von etwa 0.25mm bis etwa 2.5mm können wärmeleitend mit Gebäudestrukturen verbunden werden, die dazu geeignet sind, im Falle eines Brandes Wärme abzuleiten. Sie bilden zudem einen Schutz vor mechanischen Beschädigungen.

Optional kann die Schutzschicht in einem geringen Abstand zur Aussenplatte angeordnet sein, wodurch die Übertragung von Wärme durch Wärmeleitung weiter erschwert wird. Dies kann insbesondere dadurch erreicht werden, dass die Schutzschicht durch eingeprägte dreidimensionale Strukturen wie z.B. zur Aussenplatte hin hervorragende Rippen oder durch andere geeignete Abstandhalter leicht beabstandet zur Aussenplatte gehalten ist. Es genügt bereits ein kleiner Abstand in der Grössenordnung von einem Millimeter. Durch dreidimensionale Strukturen bzw. Prägungen kann insbesondere bei Blechen die Stabilität bzw. Steifigkeit erhöht werden.

Der schmale Freiraum zwischen der Schutzschicht und der Aussenplatte wirkt als Isolationsschicht, welche die Wärmeübertragung vom Aussenraum an die Aussenplatte erschwert.

Zusätzlich oder alternativ kann die Schutzschicht mindestens eine Aussparung bzw. Öffnung aufweisen, durch welche von der Aussenplatte abgegebener Wasserdampf in den Aussenraum ausströmen kann. Insbesondere kann die Schutzschicht z.B. ein perforiertes Lochblech oder eine poröse Folie umfassen, wobei Öffnungen verteilt über die Fläche der Schutzschicht angeordnet sind.

Alternativ können Schutz- bzw. Reflexionsschichten auch geschlossen sein, sodass Wasserdampf aus der Aussenplatte nur in Richtung des Zwischenraums abgegeben werden kann, falls ein solcher vorhanden ist.

Alternativ oder zusätzlich kann auch im Zwischenraum, insbesondere an der Aussenseite der Innenplatte in analoger Weise eine Schutz- bzw. Reflexionsschicht, insbesondere eine Metallplatte angeordnet sein. Ausführungsformen mit Aussenplatten, die aus dem Werkstoff "Aestuver" bzw. zementgebundenem, glasfaserverstärktem Leichtbeton gefertigt sind, sind druckfest und haben glatte, harte Oberflächen. Ihre Dichte ist in den Oberflächenbereichen grösser als im Inneren der Platte. Es ist in der Regel nicht erforderlich, die Oberflächen zusätzlich zu schützen. Die Kantenbereiche sind hingegen empfindlicher. Vorzugsweise werden solche Platten in den Kantenbereichen z.B. durch Schutzprofile zusätzlich gegen mechanische Beschädigungen geschützt. Im Vergleich zu ganzflächigen Schutzschichten aus Metall, wie sie z.B. bei Gipsplatten üblich sind, ist das Gewicht von Kantenschutzelementen deutlich geringer.

Auch bei Befestigungselementen zum Verbinden solcher Platten mit einem oder mehreren weiteren Elementen ist besondere Sorgfalt geboten, damit die Platten nicht beschädigt werden. Vorzugsweise werden deshalb Befestigungselemente wie z.B. Scharniere mittels Klemmvorrichtungen mit der Platte verbunden. Selbstverständlich kann diese Technik auch bei Platten aus anderen Werkstoffen angewendet werden. Dadurch können grosse lokale Verankerungskräfte im Platteninneren verhindert werden.

Begrenzen die Innenplatte und die Aussenplatte einen Zwischenraum kann dieser zum Aussenraum hin so abgedichtet sein, dass bei Überdruck im Aussenraum keine Luft vom Aussenraum in den Zwischenraum strömen kann. Der Zwischenraum kann zum Innenraum hin so abgedichtet sein, dass Wasserdampf vom Zwischenraum nicht in den Innenraum strömen kann. Der Zwischenraum kann zum Aussenraum hin so abgedichtet sein, dass bei Überdruck im Aussenraum keine Luft vom Aussenraum in den Zwischenraum strömen kann und kann zum Innenraum hin so abgedichtet sein, dass Wasserdampf vom Zwischenraum nicht in den Innenraum strömen kann. Ein solche Abdichtung kann beispielsweise mittels eines Ventils und/oder einer Klappe und/oder einer Wasserdampfsperre bereitgestellt werden.

Begrenzen die Innenplatte und die Aussenplatte einen Zwischenraum kann die Wandung des Brandschutzgehäuses mindestens eine Aussenöffnung umfassen, die den Zwischenraum mit dem Aussenraum verbindet. Die Aussenplatte kann die Aussenöffnung umfassen. Bei Seitenwänden sind solche Aussenöffnungen vorzugsweise Aussparungen, die im oberen Bereich der Aussenplatte, z.B. in deren oberstem Viertel angeordnet sind. Falls an der Aussenplatte eine Schutzschicht angeordnet ist, umfasst auch diese im Bereich der Aussenöffnung eine entsprechende Aussparung. Die Aussenöffnung dient zum Abführen von Wärme aus dem Zwischenraum. Warme Luft und Wasserdampf, die bei Ausführungsformen mit beabstandeten Platten im Zwischenraum aufgrund ihrer geringeren Dichte aufsteigen, können so einfach aus dem Zwischenraum nach aussen strömen.

Bei weiteren Ausführungsformen des Brandschutzgehäuses können in analoger Weise auch im unteren Bereich der Aussenplatte, z.B. in deren unterstem Viertel, Aussparungen angeordnet sein. Dies ermöglicht eine Luftzirkulation im Zwischenraum, wobei kühlere Luft unten in den Zwischenraum eintritt, dort Wärme und Wasserdampf aufnimmt, und oben wieder aus dem Zwischenraum ausströmt. Dies bewirkt einen zusätzlichen Kühleffekt. Bei weiteren Ausführungsformen können Zwischenräume von seitlichen Wandungsbereichen miteinander und/oder mit untenliegenden Zwischenräumen eines Gehäusebodens und/oder obenliegenden Zwischenräumen einer Gehäusedecke des Brandschutzgehäuses verbunden sein. Aussenöffnungen, die den Zwischenraum der Wandung mit dem Aussenraum verbinden, können demnach auch bei der Gehäusedecke und/oder beim Gehäuseboden angeordnet sein.

Öffnungen für Kabeldurchführungen des Brandschutzgehäuses können zusätzlich auch als Aussenöffnungen zum Abführen von Wasserdampf aus dem Zwischenraum verwendet werden. Dabei sollte sichergestellt sein, dass der Aussenraum auch im Falle eines Brandes über die Aussenöffnungen mit dem Zwischenraum verbunden bleibt.

Kabel, welche durch die Wandung des Brandschutzgehäuses hindurchgeführt werden, können z.B. mittels Kabeldurchführungen an der Innenplatte befestigt werden. Solche Kabeldurchführungen können im Bereich einer Innenöffnung an der Innenplatte befestigt werden und die Funktion einer Zugentlastung übernehmen.

Wenn die Temperatur im Aussenraum ansteigt, wird bei Gips etwa ab 85°C kristallin gebundenes Wasser freigesetzt und verdampft. Bei Platten die glasfaserverstärkten Leichtbeton umfassen ist diese Temperatur höher. Durch diesen endothermen Prozess wird die Wandung gekühlt, sodass deren Temperatur und die Temperatur im Innenraum des Brandschutzgehäuses nur verzögert und langsam ansteigen. Bei ausgebildeter Aussenöffnung und augebildetem Zwischenraum kann in den Zwischenraum abgegebener Wasserdampf durch die Aussenöffnung der Wandung vom Zwischenraum in den Aussenraum strömen, wobei Wärme aus dem Brandschutzgehäuse abgeführt wird. Im Weiteren verhindern oder erschweren solche Anordnungen das Eindringen von heissem Wasserdampf in den Innenraum des Brandschutzgehäuses. Dies ermöglicht zuverlässig einen langen Funktionserhalt von elektronischen Baugruppen im Innenraum.

Im Vergleich zu einem Brandschutzgehäuse mit einer Wandung, bei der identische Aussen- und Innenplatten ohne Zwischenraum direkt aneinander angrenzen, kann die Temperatur im Innenraum bei sonst gleichen Bedingungen länger unterhalb eines vorgegebenen Grenzwertes von beispielsweise 70°C gehalten werden.

Begrenzen die Innenplatte und die Aussenplatte einen Zwischenraum kann der Abstand zwischen der Aussenplatte und der Innenplatte z.B. in der Grössenordnung von etwa 0.5cm bis etwa 1.5cm, beispielsweise etwa 1cm liegen. Insbesondere vergleichsweise grosse Standgehäuse umfassen in der Regel Wandungen mit einem Zwischenraum. Bei kleineren Wandgehäusen können Innen- und Aussenplatten auch ohne Zwischenraum aneinander anliegen. Elemente eines Gestells, das die Wandung oder einen Abschnitt der Wandung trägt, sind vorzugsweise im Zwischenraum zwischen der Innenplatte und der Aussenplatte angeordnet. Im Falle eines Brandes sind diese Elemente, die eine tragende Funktion haben, vor grosser Hitze geschützt und behalten ihre Stabilität.

Das Gestell und die Wandung des Brandschutzgehäuses sind stabil, sodass der Innenraum effizient und effektiv vor Hitze im Aussenraum geschützt ist. Die gesamte Dicke der Wandung und das Gewicht des Brandschutzgehäuses sind vergleichsweise klein.

Solche Brandschutzgehäuse können modular aufgebaut sein. Insbesondere können Aussenplatten und Innenplatten mehrere gleichartige oder unterschiedliche Plattenabschnitte umfassen, die zusammengefügt an einem Gestell befestigt werden können. Solche Brandschutzgehäuse bzw. deren Bestandteile können leicht transportiert und am jeweiligen Bestimmungsort einfach zusammengebaut werden.

Optional können Brandschutzgehäuse Lüftungsöffnungen umfassen, welche den Innenraum mit dem Aussenraum verbinden und im Normalbetrieb das Abführen von Wärme aus dem Innenraum nach aussen durch Luftzirkulation ermöglichen. Dies gilt für Ausführungsformen des Brandschutzgehäuses mit oder ohne Zwischenraum. Üblicherweise werden solche Lüftungsöffnungen im Falle eines Brandes verschlossen. Dies kann z.B. durch Elemente aus einem Material erfolgen, das beim Überschreiten einer Maximaltemperatur aufschäumt und die Lüftungsöffnungen abdichtet.

Lüftungsöffnungen können so angeordnet und ausgebildet sein, dass sie nicht mit dem Zwischenraum verbunden sind. Alternativ können Lüftungsöffnungen auch mit dem Zwischenraum verbunden sein. Das Eindringen von heisser Luft aus dem Aussenraum in den Innenraum im Fall eines Brandes kann z.B. dadurch verhindert werden, dass bei den Lüftungsöffnungen nur ein an den Innenraum angrenzender Bereich abgedichtet wird. Mindestens eine Lüftungsöffnung, die vorzugsweise oben am Brandschutzgehäuse angeordnet ist, wird bei hohen Temperaturen nicht abgedichtet, sodass Wasserdampf aus dem Zwischenraum ausströmen kann.

Die Aussenplatte kann mehrlagig aus zwei glasfaserverstärkten Leichtbetonplatten ausgebildet sein. Dies gilt für Ausführungsformen des Brandschutzgehäuses mit oder ohne Zwischenraum.

Die Innenplatte kann an der Aussenseite eine wasserhaltige Platte umfassen. Zwischen der wasserhaltigen Platte und dem Innenraum kann eine wasserdampfundurchlässige Schicht ausgebildet sein. Dies gilt für Ausführungsformen des Brandschutzgehäuses mit oder ohne Zwischenraum.

Der mindestens eine Wandungsabschnitt mit einer Aussenplatte und einer Innenplatte kann eine Tür sein, die mittels eines Scharniers schwenkbar an einer angrenzenden Seitenwand angelenkt ist. Dies gilt für Ausführungsformen des Brandschutzgehäuses mit oder ohne Zwischenraum.

Das Scharnier kann mittels je einer Klemmvorrichtung an der Tür und an der Seitenwand befestigt sein, wobei die Klemmvorrichtung Klemmplatten zum Festklemmen an der Tür und an der Seitenwand umfasst. Die Klemmplatten können Löcher aufweisen und mit der Tür zwischen den Klemmplatten angeordnet sein, wobei die Tür mittels eines durch die Aussenplatte, die Innenplatte und die Löcher der beiden Platten durchgesteckten Bolzens zwischen den Klemmplatten festgeklemmt ist. Zum Festklemmen kann der Bolzen Festklemmmittel umfassen. Beispielsweise kann der Bolzen an einem Ende einen den Bolzen radial nach Aussen überragenden Bolzenkopf und am anderen Ende ein Aussengewinde und eine Mutter als Festklemmmittel umfassen. Dies gilt für Ausführungsformen des Brandschutzgehäuses mit oder ohne Zwischenraum.

Die Wandung des Brandschutzgehäuses kann zwei Wandungsabschnitte mit einer Aussenplatte und einer Innenplatte umfassen, die durch das Gestell beabstandet zueinander gehalten sind, sodass sie je einen zugehörigen Zwischenraum begrenzen, und dass diese Zwischenräume durchgehend miteinander verbunden sind.

Eine Aussenöffnung an der Aussenplatte zusammen mit einer Innenöffnung an der Innenplatte kann als Durchführöffnung für Kabel und/oder als Lüftungsöffnung zum Abführen von Wärme aus dem Innenraum durch Luftzirkulation nutzbar sein. Dies gilt für Ausführungsformen des Brandschutzgehäuses mit oder ohne Zwischenraum.

Die Aussenplatte und/oder die Innenplatte können aus mehreren stirnseitig aneinander angrenzenden Abschnitten zusammengesetzt sein. Dies gilt für Ausführungsformen des Brandschutzgehäuses mit oder ohne Zwischenraum.

Das Brandschutzgehäuse kann einen Türrahmen umfassen und am Türrahmen kann eine dilatierende Dichtung zur Dichtung eines Türspalts, der sich bei geschlossener Tür quer zur Türebene und um die Tür erstreckt, so angebracht sein, dass diese bei geschlossener Tür und im Brandfall durch Dilatation den Türspalt abdichtet und eine resultierende Kraft parallel zur Türebene und zur Tür hin bewirkt. Dies gilt für Ausführungsformen des Brandschutzgehäuses mit oder ohne Zwischenraum.

Die Seitenwand kann eine Aussparung umfassen, die dazu ausgelegt ist einen an der Innenseite der Tür befestigten quer zur Türebene vorstehenden Vorsprung beim Schliessen der Tür bzw. bei geschlossener Tür durch Eingreifen des Vorsprungs in die Aussparung aufzunehmen, sodass die Tür sich im geschlossenen Zustand nicht vom Brandschutzgehäuse lösen kann auch wenn die Scharniere ihre Funktion nicht mehr erfüllen, beispielsweise durch den Brand zerstört sind.

Anhand einiger Figuren wird die Erfindung im Folgenden näher beschrieben. Dabei zeigen
- Figur 1: ein Brandschutzgehäuse mit geschlossener Tür in einer perspektivischen Ansicht,
- Figur 2: das Brandschutzgehäuse aus Figur 1 mit geöffneter Tür,
- Figur 3: eine Ansicht entlang der Linie C-C in Figur 5 aufgeschnittenen Brandschutzgehäuses
- Figur 4: eine Frontansicht des Brandschutzgehäuses aus Figur 1,
- Figur 5: eine Ansicht des entlang der Linie A-A in Figur 4 aufgeschnittenen Brandschutzgehäuses,
- Figur 6: eine Aufsicht auf das entlang der Linie B-B in Figur 4 aufgeschnittene Brandschutzgehäuse,
- Figur 7: einen Detailquerschnitt im Bereich zweier miteinander verbundener Wandungsabschnitte eines Brandschutzgehäuses,
- Figur 8: einen Detailquerschnitt der Wandung eines weiteren Brandschutzgehäuses,
- Figur 9: einen Detailquerschnitt im Bereich eines Profilkörpers zum Verbinden von Wandungsabschnitten,
- Figur 10: einen Detailquerschnitt einer Wandung mit Öffnungen, die zum Durchführen von Kabeln und/oder als Lüftungsöffnungen nutzbar sind,
- Figur 11: einen Detailquerschnitt im Eckbereich eines Wandungsabschnitts mit einem Scharnier und einer angelenkten Tür,
- Figur 12: einen Detailquerschnitt im Eckbereich eines gegenüberliegenden Wandungsabschnitts und der Tür.

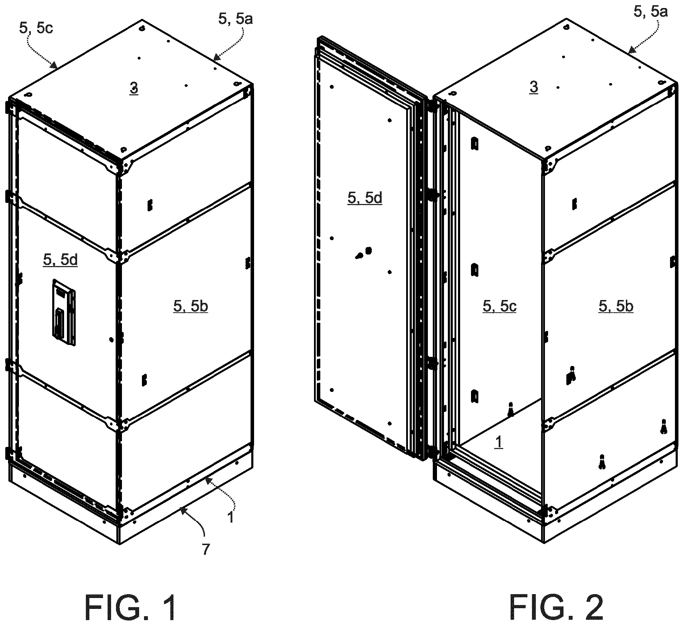

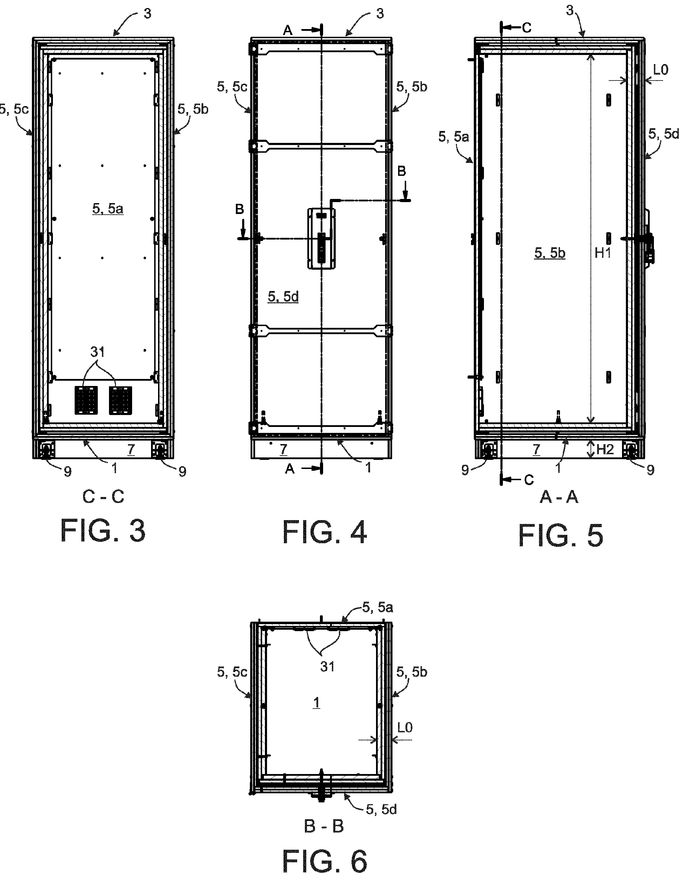

Ein beispielhaftes Brandschutzgehäuse mit einer Wandung, die einen Innenraum umschliesst und gegenüber einem Aussenraum begrenzt, ist in den Figuren 1 und 2 perspektivisch dargestellt. Die Wandung umfasst einen Gehäuseboden 1, eine Gehäusedecke 3 und vier seitliche Gehäusewände 5, nämlich eine Rückwand 5a, zwei daran angrenzende Seitenwände 5b, 5c und eine Tür 5d, die schwenkbar an der angrenzenden Seitenwand 5c angelenkt ist. Bei der Anordnung in Figur 1 ist die Tür 5d geschlossen, bei jener in Figur 2 geöffnet. Bei der dargestellten Ausführungsform umfasst das Brandschutzgehäuse zusätzlich einen Sockel 7, auf dem der Gehäuseboden 1 aufliegt. Vorzugsweise umfasst der Sockel 7 vier Stützfüsse 9, von denen mindestens zwei höhenverstellbar ausgebildet sind (Figuren 5 und 6).

Der Innenraum des Brandschutzgehäuses hat eine Höhe H1 von beispielsweise etwa 200 cm. Allgemein kann die Höhe H1 entsprechend der Gegebenheiten am jeweiligen Bestimmungsort vorgegeben werden. Dies gilt auch für die Höhe H2 des Sockels 7, die beispielsweise etwa 10cm betragen kann.

Figur 4 zeigt eine Frontansicht des Brandschutzgehäuses, Figur 5 eine Seitenansicht des entlang der Linie A-A in Figur 4 aufgeschnittenen Brandschutzgehäuses, Figur 3 eine Frontansicht des entlang der Linie C-C in Figur 5 aufgeschnittenen Brandschutzgehäuses und Figur 6 eine Aufsicht des entlang der Linie B-B in Figur 4 aufgeschnittenen Brandschutzgehäuses.

Bei diesem Brandschutzgehäuse sind mit Ausnahme der Rückwand 5a alle Gehäusewände 5 zweischalig ausgebildet. Die Dicke L0 der Wandung in solchen zweischaligen Bereichen kann je nach Aufbau des Brandschutzgehäuses unterschiedlich sein. Sie kann z.B. etwa 10 cm betragen. Die Rückwand 5a ist bei der in den Figuren 1 bis 6 dargestellten Ausführungsform des Brandschutzgehäuses dazu bestimmt am jeweiligen Bestimmungsort direkt mit einem wärmeleitenden Element, z.B. einer armierten Betonwand, in Kontakt gebracht zu werden. Allgemein umfasst das Brandschutzgehäuse mindestens einen zweischaligen Wandungsabschnitt.

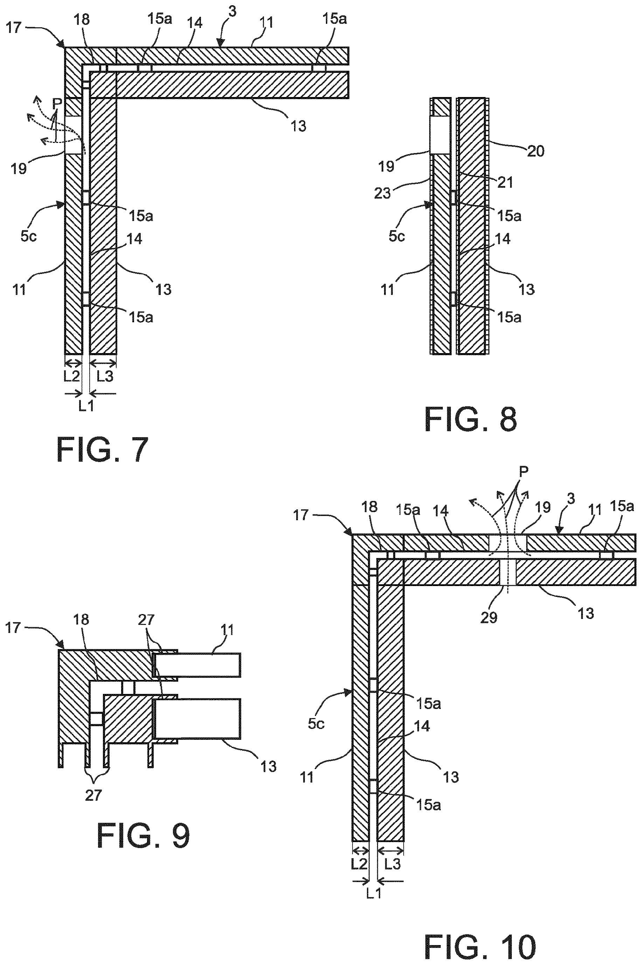

Figur 7 zeigt schematisch einen Detailquerschnitt im Kantenbereich zweier rechtwinklig aneinander angrenzenden zweischaligen Gehäusewände 5, z.B. der Seitenwand 5c und der Gehäusedecke 3.

Die zweischaligen Wandungsabschnitte umfassen je eine Aussenplatte 11 und eine Innenplatte 13, die durch Streben 15a eines Gestells 15 beabstandet zueinander gehalten sind, sodass sie einen Zwischenraum 14 begrenzen. In der Regel sind die Streben 15a des Gestells 15 Hohlprofile oder alternativ Vollprofile aus Metall, beispielsweise Vierkantrohre aus hitzebeständigem Stahl.

Vorzugsweise sind die Streben 15a im Zwischenraum 14 zwischen den Platten 11, 13 angeordnet. Dadurch können sie die Funktion von Abstandhaltern übernehmen, welche die Breite L1 des Zwischenraums 14 definieren. Zudem sind die Streben 15a geschützt vor Hitze im Aussenraum angeordnet, sodass sie auch im Fall eines Brandes zuverlässig ihre Funktion als stabile Tragkonstruktion beibehalten. Die Streben 13a können quer zu Ihrer Längsrichtung durchgehende Ausnehmungen aufweisen. Diese ermöglichen eine verbesserte Zirkulation von Luft und Wasserdampf im Zwischenraum 14.

Mindestens eine der Aussenplatten 11 umfasst eine oder mehrere durchgehende Aussenöffnungen 19, durch die Wasserdampf aus dem Zwischenraum 14 in den Aussenraum ausströmen kann. Dies ist in Figur 7 symbolisch durch die gepunkteten Pfeile P dargestellt.

Die Breite des Zwischenraums 14 bzw. der Abstand L1 von sich gegenüberliegenden Platten 11, 13 ist in der Regel bei allen zweischaligen Gehäusewänden 5 gleich gross. Er liegt z.B. in der Grössenordnung von etwa 0.5cm bis etwa 1.5cm und ist vorzugsweise kleiner oder gleich 1cm.

Bei alternativen Ausführungsformen des Brandschutzgehäuses kann dessen Wandung jedoch auch Abschnitte umfassen, bei denen der Plattenabstand L1 unterschiedlich und/oder grösser ist.

Bei den zwei in Figur 7 dargestellten Wandungsabschnitten ist die Breite L1 des Zwischenraums 14 gleich gross. Die beiden Innenplatten 13 und die beiden Aussenplatten 11 sind z.B. mittels eines Profilkörpers 17 im Bereich ihrer Seitenkanten miteinander verbunden. Der Profilkörper 17 kann eine oder mehrere Verbindungsöffnungen 18 umfassen, welche die Zwischenräume 14 der beiden Wandungsabschnitte durchgehend miteinander verbinden.

Alternativ könnten Zwischenräume 14 von mehreren Wandungsabschnitten z.B. durch Profilkörper 17 ohne Verbindungsöffnungen 18 und/oder Streben 13a voneinander getrennt sein. Vorzugsweise ist dabei jeder Zwischenraum 14 über mindestens eine Aussenöffnung 19 in der daran angrenzenden Aussenplatte 11 mit dem Aussenraum verbunden.

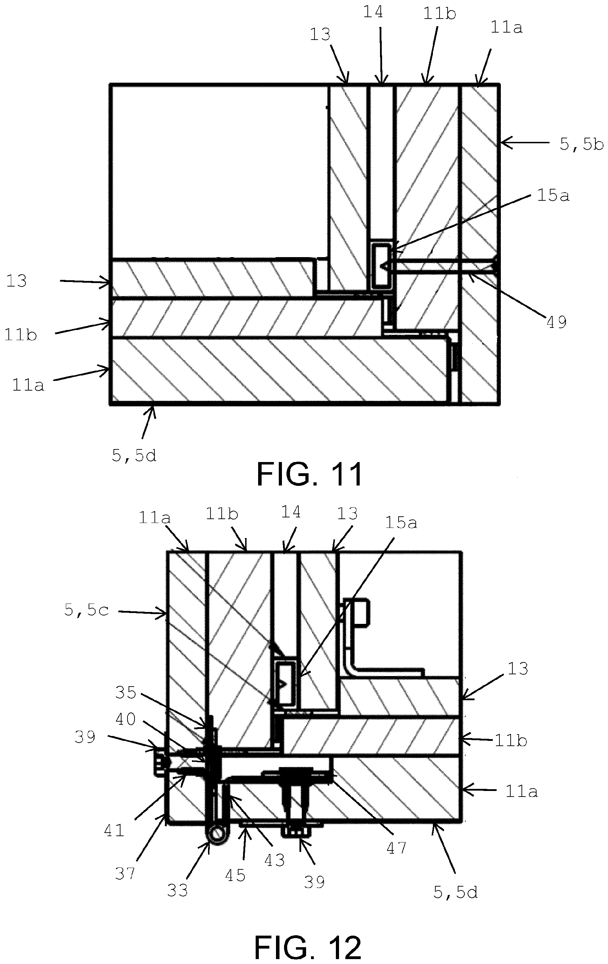

Jede Aussenplatte 11 umfasst mindestens eine Lage bzw. Schicht eines Werkstoffs, der gebundenes Wasser enthält, vorzugsweise eine faserverstärkte Leichtbetonplatte oder eine Bauplatte mit Gips bzw. eine Gipsfaserplatte. Bei Aussenplatten 11 können eine oder mehrere Platten gleicher oder unterschiedlicher Dicke z.B. durch eine Klemmverbindung aneinander anliegend zusammengehalten sein. Die gesamte Dicke L2 jeder der Aussenplatten 11 liegt in der Regel in der Grössenordnung von etwa 1cm bis etwa 3cm, vorzugsweise im Bereich von 1.5cm bis 2.5cm. Optional können Aussenplatten 11 mehrere Schichten oder Lagen umfassen, die aus demselben oder aus unterschiedlichen Materialien gefertigt sind, z.B. eine äussere Aussenplatte 11a und eine innere Aussenplatte 11b (Fig. 11 und 12). Die vorstehend angegebenen Masse gelten bei solchen Ausführungsformen für jede der Aussenplatten 11a, 11b). Insbesondere können Aussenplatten 11 z.B. aussen eine Platte aus stabilem Leichtbeton und innen eine Bauplatte mit Gips umfassen.

Die Innenplatte 13 hat in der Regel eine Dicke L3 in der Grössenordnung von etwa 1cm bis etwa 5cm. Innenplatten 13 können eine oder mehrere Lagen aus gleichen oder aus unterschiedlichen Materialien umfassen, wobei vorzugsweise mindestens eine dieser Lagen aus einem thermisch isolierenden Werkstoff gefertigt ist, beispielsweise eine glasfaserverstärkte Leichtbetonplatte, eine Mitteldichte Holzfaserplatte (MDF), eine Platte auf Basis von CalciumSilikat, die z.B. mit Kohlefasern verstärkt sein kann, oder eine organisch gebundene Wärmeschutzplatte. Vorzugsweise hat die Platte eine Wärmeleitfähigkeit λ ⇐ 0.25 W/m K.

Die Innenplatte 13 kann mehrere miteinander verbundene Platten mit gleichen oder mit unterschiedlichen Dicken umfassen.

Figur 8 zeigt schematisch einen Detailquerschnitt einer Seitenwand 5a mit optionalen Funktionsschichten. So kann z.B. die Innenplatte 13 optional auf der dem Zwischenraum 14 zugewandten Aussenseite eine Platte mit gebundenem Wasser, insbesondere eine Brandschutzplatte umfassen. Vorzugsweise ist zwischen dieser wasserhaltigen Platte und dem Innenraum eine wasserdampfundurchlässige Schicht 20 ausgebildet. Dadurch wird sichergestellt, dass aus der wasserhaltigen Platte austretender Wasserdampf nicht in den Innenraum des Brandschutzgehäuses gelangen kann.

Optional kann an der äusseren Seite der Innenplatte 13, die gegebenenfalls dem Zwischenraum 14 zugewandt ist, eine Wärmestrahlung reflektierende Schicht 21 angeordnet sein, z.B. eine Aluminiumfolie. Diese Schicht 21 kann z.B. perforiert sein, sodass gegebenenfalls aus einer wasserhaltigen Platte der Innenplatte 13 austretender Wasserdampf in den Zwischenraum 14 ausströmen kann.

Optional kann auf der Aussenseite der Aussenplatte 11 eine Schutzschicht 23 angeordnet sein, beispielsweise ein dünnes, Wärmestrahlung reflektierendes Metallblech. Vorzugsweise umfasst ein solches Metallblech eingeprägte dreidimensionale Strukturen wie z.B. in Richtung der Aussenplatte 11 hervorragende Rippen (nicht dargestellt). Diese erhöhen die Stabilität des Blechs und erschweren die Übertragung von Wärme durch Wärmeleitung an die Aussenplatte 11. Die Aussenöffnung 19 ist durchgehend auch im Abschnitt des Metallblechs ausgebildet. Bei weiteren alternativen Ausführungsformen könnte die Aussenseite der Aussenplatte 11 mit einer Wärmestrahlung reflektierenden Folie wie z.B. Aluminiumfolie verkleidet sein oder eine abgeschiedene dünne, Wärme reflektierende Metallschicht umfassen. Aussenplatten 11, die aus stabilem Leichtbeton gefertigt sind, insbesondere aus zementgebundenem, glasfaserverstärktem Leichtbeton, sind ausreichend stabil und haben eine optisch ansprechende glatte und harte Oberfläche. In der Regel ist bei solchen Platten keine Überdeckung mit einem Metallblech erforderlich. Hingegen ist es vorteilhaft, bei solchen Platten einen Kantenschutz vorzusehen. Dies gilt sinngemäss auch für Innenplatten, deren Kanten an exponierten Stellen angeordnet sind.

Die Aussenplatten 11 und Innenplatten 13 von Gehäusewänden 5 können einstückig ausgebildet oder aus mehreren, beispielsweise zwei, drei oder vier Abschnitten zusammengesetzt sein. Benachbarte Abschnitte grenzen jeweils stirnseitig aneinander. Sie können z.B. durch das Gestell 15 und/oder durch andere Verbindungsmittel zusammengehalten werden. Insbesondere können für diesen Zweck z.B. Profilkörper 17 vorgesehen sein, die im Querschnitt U-förmige Nuten 27 zum Aufnehmen von Endbereichen bzw. Kanten von Abschnitten der Aussenplatten 11 und/oder der Innenplatten 13 umfassen, wie dies in Figur 9 dargestellt ist. Solche Profilkörper 17, die sich paarweise gegenüberliegen, definieren einen Rahmen zum Zusammenfügen und Halten eines oder mehrerer Abschnitte einer Gehäusewand 5. Solche Profilkörper 17 können z.B. mit den Streben 15a des Gestells 15 verbunden werden. Auf diese Weise können Brandschutzgehäuse unterschiedlicher Grössen modular aus vergleichsweise wenigen Elementen einfach zusammengebaut werden. Die einzelnen Abschnitte der Gehäusewände 5 sind vergleichsweise leicht und klein. Dadurch können Brandschutzgehäuse effizient hergestellt werden. Der Platzbedarf zum Lagern von wenigen standardisierten Teilen ist klein, und die Teile können einfach transportiert und zu einem Gehäuse zusammengesetzt werden. Insbesondere kann der Zusammenbau bei Bedarf erst am jeweiligen Bestimmungsort des Brandschutzgehäuses erfolgen.

Figur 10 zeigt eine ähnliche Anordnung wie in Figur 7. Im Unterschied dazu ist die Aussenöffnung 19 in der Aussenplatte 11 der Gehäusedecke 3 ausgebildet. Zusammen mit einer darunter angeordneten Innenöffnung 29 an der Innenplatte 13 kann sie z.B. zum Hindurchführen von Kabeln durch die Wandung des Brandschutzgehäuses verwendet werden und/oder die Funktion einer Lüftungsöffnung haben. Solange die Temperatur im Aussenraum kleiner ist als im Innenraum, kann über diese Lüftungsöffnung durch Luftzirkulation Wärme aus dem Brandschutzgehäuse in den Aussenraum abgeführt werden. Vorzugsweise umfasst das Brandschutzgehäuse im unteren Bereich mindestens eine weitere Lüftungsöffnung, durch die kühlere Luft aus dem Aussenraum in den Innenraum einströmen kann. So umfasst z.B. das Brandschutzgehäuse gemäss den Figuren 1 bis 6 im unteren Bereich der Rückwand 5a Lüftungsöffnungen. Vorzugsweise sind im Bereich dieser Lüftungsöffnungen Filterelemente 31 angeordnet zum Reinigen von Luft, die aus dem Aussenraum in den Innenraum einströmt. Brandschutzgehäuse mit Lüftungsöffnungen können Mittel umfassen, mit denen diese Lüftungsöffnungen bei hohen Temperaturen im Aussenraum verschlossen bzw. abgedichtet werden können. Solche Mittel sind z.B. Schliessklappen, die gesteuert durch einen Temperatursensor beim Übersteigen einer vorgegebenen Maximaltemperatur in eine Schliesslage bewegt werden. Alternativ können z.B. auch Kunststoffelemente verwendet werden, die durch Hitze aufschäumbar sind.

Bei Lüftungsöffnungen im Bereich von zweischaligen Wandungsabschnitten wird dabei nur die Innenöffnung 29 an der Innenplatte 13 geschlossen. Die Aussenöffnung 19 an der Aussenplatte 11 bleibt auch bei hohen Temperaturen im Aussenraum frei, sodass Wasserdampf aus dem Zwischenraum 14 in den Aussenraum ausströmen kann.

Figur 11 zeigt einen Detailquerschnitt im Eckbereich der Seitenwand 5b und der Tür 5d eines Brandschutzgehäuses, Figur 12 einen Detailquerschnitt im gegenüberliegenden Eckbereich, wo die Tür 5d mittels eines Scharniers schwenkbar an der Seitenwand 5c angelenkt ist.

Die Tür 5d umfasst drei Platten, nämlich eine äussere Aussenplatte 11a, eine daran anliegende innere Aussenplatte 11b und eine Innenplatte 13. Die äussere Aussenplatte 11a hat vorzugsweise eine Dicke von etwa 25mm, und die Dicken der inneren Aussenplatte 11b und der Innenplatte 13 betragen je etwa 15mm.

Die Seitenwände 5b, 5c umfassen ebenfalls drei Platten. Im Unterschied zur Anordnung der Platten bei der Tür 5d haben die äussere Aussenplatte 11a und die Innenplatte 13 je eine Dicke von etwa 15mm und die innere Aussenplatte 11b eine Dicke von etwa 25mm. Zusätzlich sind die innere Aussenplatte 11b und die Innenplatte 13 durch Streben 15a in Gestalt rechteckiger Aluprofile beabstandet zueinander gehalten, sodass sie einen Zwischenraum 14 mit einer Breite von etwa 10mm begrenzen. Die Aussenplatten 11a, 11b sind mittels Schrauben 49 mit der Strebe 15 verbunden.

Das Scharnier umfasst einen Zapfen 33, an dem seitlich ein erstes Scharnierblech 35 hervorragt. Der Zapfen 33 ist aussen angrenzend an eine äussere Aussenplatte 11a der Tür 5d angeordnet. Das erste Scharnierblech 35 liegt im Randbereich innen an einer äusseren Aussenplatte 11a der Seitenwand 5c an. Gegenüberliegend liegt ein erster Schenkel eines im Querschnitt L-förmigen Verstärkungsprofils 37 aussen an der äusseren Aussenplatte 11a an. Der zweite Schenkel dieses Verstärkungsprofils 37 liegt stirnseitig aussen an der äusseren Aussenplatte 11a an. Das Verstärkungsprofil 37 erstreckt sich vorzugsweise über die gesamte Höhe der Seitenwand 5c und schützt so deren Kantenbereich. In analoger Weise können auch weitere Kanten von Platten des Brandschutzgehäuses geschützt werden, insbesondere jene Kanten, die exponiert sind und beschädigt werden könnten. Ein Randbereich der äusseren Aussenplatte 11a ist mittels einer Klemmschraube 39 zwischen dem aussen anliegenden Schenkel des Verstärkungsprofils 37 und dem ersten Scharnierblech 35 festgeklemmt. Dabei durchdringt die Klemmschraube 39 eine Bohrung 41 in der äusseren Aussenplatte 11a und ist an der gegenüberliegenden inneren Seite der Aussenplatte 11a mit einem Klemmblech 40 mit einem Innengewinde verschraubt. Die Klemmkraft wirkt verteilt über die Fläche des ersten Scharnierblechs 35. Allgemein ist das Scharnier ein Befestigungselement, das mittels einer Klemmvorrichtung an der Aussenplatte 11 befestigt ist. Die Klemmvorrichtung umfasst den ersten Schenkel des Verstärkungsprofils 37 als äusseres Klemmblech, das innere Klemmblech 40 mit dem Innengewinde und die Klemmschraube 39.

Vorzugsweise hat die Klemmschraube 39 einen exzentrischen Schaft zum Verstellen bzw. Justieren der Lage des Scharnierblechs 35 relativ zur Aussenplatte 11a. Alternativ können auch andere Justiermittel für diesen Zweck vorgesehen sein.

Ein weiteres Scharnierblech 43 ist schwenkbar am Zapfen 33 gelagert und im Querschnitt L-förmig ausgebildet, wobei ein erster Schenkel stirnseitig an einer äusseren Aussenplatte 11a der Tür 5d anliegt und ein zweiter Schenkel innenseitig an einem Absatz einer Ausnehmung der äusseren Aussenplatte 11a. Auch bei der Tür 5d ist die äussere Aussenplatte 11a in analoger Weise mittels einer Klemmschraube 39 zwischen einem aussenseitigen Klemmblech 45 und dem zweiten Schenkel des Scharnierblechs 43 als innenseitigem Klemmblech 47 mit einem Innengewinde mittels einer Klemmschraube 39 geklemmt gehalten.

Die in den Figuren 11 und 12 dargestellten Anordnungen sind als beispielhafte Ausführungsformen zu verstehen. Die Aussenplatten 11a, 11b und Innenplatten können z.B. alle aus glasfaserverstärktem Leichtbeton gefertigt sein.

Die Tür 5d ist flächenbündig einschlagend und mit einer umlaufenden Dichtung versehen. Die Türscharniere sind aus Edelstahl gefertigt. Vorzugsweise gilt dies allgemein für Befestigungselemente.

## Patentansprüche

1. Brandschutzgehäuse umfassend eine Wandung, die einen Innenraum umschliesst und gegenüber einem Aussenraum begrenzt, **dadurch gekennzeichnet, dass** die Wandung mindestens einen Wandungsabschnitt mit einer Aussenplatte (11) und einer Innenplatte (13) umfasst, und zumindest die Aussenplatte (11) ein Material mit gebundenem Wasser in der Form von glasfaserverstärktem Leichtbeton umfasst.

2. Brandschutzgehäuse nach Anspruch 1, **dadurch gekennzeichnet, dass** die Aussenplatte (11) und die Innenplatte (13) durch ein Gestell (15) beabstandet zueinander gehalten sind und einen Zwischenraum (14) zwischen dem Innenraum und dem Aussenraum begrenzen und, dass die Aussenplatte (11) mindestens eine Aussenöffnung (19) umfasst, die den Zwischenraum (14) mit dem Aussenraum verbindet oder dass der Zwischenraum zum Aussenraum hin so abgedichtet ist, dass bei Überdruck im Aussenraum keine Luft vom Aussenraum in den Zwischenraum strömen kann oder dass der Zwischenraum zum Innenraum hin so abgedichtet ist, dass Wasserdampf vom Zwischenraum nicht in den Innenraum strömen kann, oder dass der Zwischenraum zum Aussenraum hin und zum Innenraum hin so abgedichtet ist, dass bei Überdruck im Aussenraum keine Luft vom Aussenraum in den Zwischenraum strömen kann und dass Wasserdampf vom Zwischenraum nicht in den Innenraum strömen kann.

3. Brandschutzgehäuse nach einem der Ansprüche 1 oder 2, **dadurch gekennzeichnet, dass** die Aussenplatte (11) mehrlagig aus mindestens zwei glasfaserverstärkten Leichtbetonplatten ausgebildet ist.

4. Brandschutzgehäuse nach einem der Ansprüche 1 bis 3, **dadurch gekennzeichnet, dass** an der Aussenseite der Aussenplatte (11) eine Wärmestrahlung reflektierende Schutzschicht (23) angeordnet ist.

5. Brandschutzgehäuse nach einem der Ansprüche 1 bis 4, **dadurch gekennzeichnet, dass** die Innenplatte (13) eine wärmedämmende Platte umfasst.

6. Brandschutzgehäuse nach einem der Ansprüche 1 bis 5, **dadurch gekennzeichnet, dass** an der Aussenseite der Innenplatte (13) eine Wärmestrahlung reflektierende Schicht (21) angeordnet ist.

7. Brandschutzgehäuse nach einem der Ansprüche 1 bis 6, **dadurch gekennzeichnet, dass** die Innenplatte (13) an der Aussenseite eine wasserhaltige Platte umfasst.

8. Brandschutzgehäuse nach Anspruch 7, **dadurch gekennzeichnet, dass** zwischen der wasserhaltigen Platte und dem Innenraum eine wasserdampfundurchlässige Schicht (20) ausgebildet ist.

9. Brandschutzgehäuse nach einem der Ansprüche 1 bis 8, **dadurch gekennzeichnet, dass** der mindestens eine Wandungsabschnitt mit einer Aussenplatte (1) und einer Innenplatte (13) eine Tür (5d) ist, die mittels eines Scharniers schwenkbar an einer angrenzenden Seitenwand des Brandschutzgehäuses (5c) angelenkt ist.

10. Brandschutzgehäuse nach Anspruch 9, **dadurch gekennzeichnet, dass** das Scharnier mittels je einer Klemmvorrichtung an der Tür (5d) und an der Seitenwand (5c) befestigt ist, wobei die Klemmvorrichtungen Klemmplatten zum Festklemmen der Tür (5d) bzw. der Seitenwand (5c) zwischen den Klemmplatten umfasst.

11. Brandschutzgehäuse nach einem der Ansprüche 2 bis 10, **dadurch gekennzeichnet, dass** dessen Wandung mindestens zwei Wandungsabschnitte mit einer Aussenplatte (11) und einer Innenplatte (13) umfasst, die durch das Gestell (15) beabstandet zueinander gehalten sind, sodass sie je einen zugehörigen Zwischenraum (14) begrenzen, und dass diese Zwischenräume (14) durchgehend miteinander verbunden sind.

12. Brandschutzgehäuse nach einem der Ansprüche 2 bis 11, **dadurch gekennzeichnet, dass** eine Aussenöffnung (19) an der Aussenplatte zusammen mit einer Innenöffnung (29) an der Innenplatte (13) als Durchführöffnung für Kabel und/oder als Lüftungsöffnung zum Abführen von Wärme aus dem Innenraum durch Luftzirkulation nutzbar ist.

13. Brandschutzgehäuse nach einem der Ansprüche 1 bis 12, **dadurch gekennzeichnet, dass** die Aussenplatte (11) und/oder die Innenplatte (13) aus mehreren stirnseitig aneinander angrenzenden Abschnitten zusammengesetzt sind.

14. Brandschutzgehäuse nach einem der Ansprüche 9 bis 13, **dadurch gekennzeichnet, dass** das Brandschutzgehäuse einen Türrahmen umfasst und am Türrahmen eine dilatierende Dichtung zur Dichtung eines Türspalts, der sich bei geschlossener Tür quer zur Türebene und um die Tür erstreckt, so angebracht ist, dass diese bei geschlossener Tür im Brandfall durch Dilatation den Türspalt abdichtet und dabei eine resultierende Kraft parallel zur Türebene und zur Tür hin bewirkt.

15. Brandschutzgehäuse nach einem der Ansprüche 9 bis 14, **dadurch gekennzeichnet, dass** die angrenzende Seitenwand eine Aussparung umfasst, die dazu ausgelegt ist einen an der Innenseite der Tür befestigten quer zur Türebene vorstehenden Vorsprung bei geschlossener Tür durch Eingreifen des Vorsprungs in die Aussparung aufzunehmen.
